# EUROPEAN PATENT APPLICATION

(11) **EP 4 686 064 A1**
(43) Date of publication of application: **28.01.2026**
(21) Application number: 24822393.5
(22) Date of filing: 19.04.2024
(51) Int. Cl.: H02M 1/14, H02M 3/04, H02M 1/00, H02M 3/00

(54) **FILTER CIRCUIT OF DIRECT-CURRENT POWER SUPPLY, FILTER, ELECTRIC DRIVE CONTROLLER, AND AUTOMOBILE**

(30) Priority: 14.06.2023 CN 202310707254
(71) Applicant: ZHEJIANG ZEEKR INTELLIGENT TECHNOLOGY CO., LTD., Ningbo, Zhejiang 315899 (CN); VIRIDI E-MOBILITY TECHNOLOGY (NINGBO) CO., LTD., Ningbo, Zhejiang 315336 (CN); Zhejiang Geely Holding Group Co., Ltd., Hangzhou, Zhejiang 310051 (CN)
(72) Inventor: LI, Mingfu, Ningbo, Zhejiang 315899 (CN); XU, Xunjin, Ningbo, Zhejiang 315899 (CN); LI, Changluo, Ningbo, Zhejiang 315899 (CN); NIU, Yaqi, Ningbo, Zhejiang 315899 (CN)
(74) Representative: Michalski Hüttermann & Partner Patentanwälte mbB
(86) International application number: PCT/CN2024/088707
(87) International publication number: WO 2024/255438

(57) **Abstract**

The present application discloses a filter circuit of a direct-current power supply, a filter, an electric drive controller, and an automobile. The filter circuit of the direct-current power supply comprises a positive direct-current bus, a negative direct-current bus, a charging cable, and a filter circuit having at least three stages. The positive direct-current bus comprises a positive direct-current bus input end and a positive direct-current bus output end. The negative direct-current bus comprises a negative direct-current bus input end and a negative direct-current bus output end. The charging cable comprises a charging cable input end and a charging cable output end. Said filter circuit is separately connected between the positive direct-current bus input end and the direct-current bus output end, between the negative direct-current bus input end and the negative direct-current bus output end, and between the charging cable input end and the charging cable output end.

## Description

### CROSS-REFERENCE TO RELATED APPLICATIONS

The present application claims priority to Chinese patent application No. 202310707254.6, filed with the Chana National Intellectual Property Administration on June 14, 2023, which is hereby incorporated by reference in its entirety.

### TECHNICAL FIELD

Embodiments of the present application relate to, but are not limited to, the field of filtering technologies, and in particular, relate to, but are not limited to, a filter circuit and filter of a direct-current power supply, an electric drive controller, and a vehicle.

### BACKGROUND

Driven by the national strategy of carbon peaking and carbon neutrality goals and supported by new energy industrialization, the new energy vehicle has experienced rapid development, especially the 800 V high-voltage and high-power density electric drive controller, represented by the third-generation wide-bandgap silicon carbide (SiC) power semiconductor, has been widely used due to the advantages of high switching frequency, low loss and good temperature resistance.

### SUMMARY

The following is a summary of subject matter described in detail herein. This summary is not intended to limit the scope of the claims. Embodiments of the present application provide a filter circuit and filter for a direct-current power supply, an electric drive controller, and a vehicle that can simultaneously supply power to a motor drive and implement a filtering function based on a boost function.

An embodiment of the present application provides a filter circuit for a direct-current power supply, including:
a positive direct-current bus, including a positive direct-current bus input terminal and a positive direct-current bus output terminal;
a negative direct-current bus, including a negative direct-current bus input terminal and a negative direct-current bus output terminal;
a charging line, including a charging line input terminal and a charging line output terminal; and
at least three stages of filter circuits, respectively connected between the positive direct-current bus input terminal and the positive direct-current bus output terminal, between the negative direct-current bus input terminal and the negative direct-current bus output terminal, and between the charging line input terminal and the charging line output terminal.

In some embodiments, the at least three stages of filter circuits include a first-stage filter magnetic ring, a second-stage filter magnetic ring, and a third-stage filter magnetic ring; where the first-stage filter magnetic ring, the second-stage filter magnetic ring, and the third-stage filter magnetic ring are connected at intervals between the positive direct-current bus input terminal and the positive direct-current bus output terminal, between the negative direct-current bus input terminal and the negative direct-current bus output terminal, and between the charging line input terminal and the charging line output terminal.

In some embodiments, the first-stage filter magnetic ring is disposed closer to the positive direct-current bus input terminal, the negative direct-current bus input terminal, and the charging line input terminal relative to the second-stage filter magnetic ring and the third-stage filter magnetic ring.

In some embodiments, the at least three stages of filter circuits further include multiple direct-current support capacitors respectively connected between the positive direct-current bus and a ground terminal, between the negative direct-current bus and a ground terminal, and between the charging line and a ground terminal.

In an embodiment, one terminal of each of the multiple direct-current support capacitors is connected to a same ground terminal.

In an embodiment, the multiple direct-current support capacitors are respectively located between the third-stage filter magnetic ring and the positive direct-current bus output terminal, between the third-stage filter magnetic ring and the negative direct-current bus output terminal, and between the third-stage filter magnetic ring and the charging line output terminal.

In some embodiments, the filter circuit for the direct-current power supply according to claim 2, where the at least three stages of filter circuits further include one or more differential-mode circuits respectively connected between every two of the positive direct-current bus, the negative direct-current bus and the charging line.

In some embodiments, the one or more differential-mode circuits are located between the first-stage filter magnetic ring and the second-stage filter magnetic ring.

In some embodiments, the one or more differential-mode circuits include at least one differential-mode capacitor.

In some embodiments, the at least three stages of filter circuits further include one or more common-mode circuits respectively connected between the positive direct-current bus and a ground terminal, between the negative direct-current bus and a ground terminal, and between the charging line and a ground terminal.

In some embodiments, the one or more common-mode circuits are respectively located between the first-stage filter magnetic ring and the second-stage filter magnetic ring, and between the second-stage filter magnetic ring and the third-stage filter magnetic ring.

In some embodiments, one terminal of each of the one or more common-mode circuits is connected to a same ground terminal.

In some embodiments, the one or more common-mode circuits include at least two common-mode capacitors.

In some embodiments, the first-stage filter magnetic ring includes an amorphous magnetic ring.

In some embodiments, the second-stage filter magnetic ring includes a ferrite magnetic ring.

In some embodiments, the third-stage filter magnetic ring includes a ferrite magnetic ring.

An embodiment of the present application further provides a filter for a direct-current power supply, where the filter of the direct-current power supply is internally provided with the filter circuit for the direct-current power supply according to any one of the above embodiments.

In some embodiments, the direct-current power supply includes a direct-current boost power supply.

An embodiment of the present application further provides an electric drive controller, including the filter for the direct-current power supply according to the above embodiments.

An embodiment of the present application further provides a vehicle, including the electric drive controller according to the above embodiments.

The filter circuit and filter for the direct-current power supply, the electric drive controller, and the vehicle in the embodiments of the present application can supply power to the motor drive and at the same time implement the filtering function based on the boost function, so that a very high resistance to insertion loss can be achieved, and a relatively strict filtering requirement can be met.

Other aspects will become apparent upon reading and understanding the drawings and detailed description.

### BRIEF DESCRIPTION OF DRAWINGS

FIG. 1 is a circuit diagram of a filter circuit for a direct-current power supply according to an embodiment of the present application.
FIG. 2 is a structural diagram of a filter for a direct-current power supply according to an embodiment of the present application.
FIG. 3 is an exploded view of the filter of FIG. 2.
FIG. 4 is a structural top view of a filter for a direct-current power supply shown in FIG. 2.
FIG. 5 is a structural diagram of a part of a filter for a direct-current power supply shown in FIG. 2.
FIG. 6 is a structural diagram of a part of a filter for a direct-current power supply shown in FIG. 2.
FIG. 7 is a structural diagram of a part of a filter for a direct-current power supply shown in FIG. 2.
FIG. 8 is a structural diagram of a part of a filter for a direct-current power supply shown in FIG. 2.

Description of reference numerals: 1-filter circuit, 2-filter, 10-positive direct-current bus, 101-positive direct-current bus input terminal, 102-positive direct-current bus output terminal, 11-negative direct-current bus, 111-negative direct-current bus input terminal, 112-negative direct-current bus output terminal, 12-charging line, 121-charging line input terminal, 122-charging line output terminal, 13-at least three stages of filter circuits, 131-first-stage filter magnetic ring, 132-second-stage filter magnetic ring, 133-third-stage filter magnetic ring, 14-direct-current support capacitor, CL1-CL3: first to third direct-current support capacitors, 15-differential-mode circuit, CX1-CX3: first to third differential-mode capacitors, 16-common-mode circuit, CY 1-CY 12: first to twelfth common-mode capacitors, 21-base, 22-power charging copper bar, 221-power charging copper bar input terminal, 222-power charging copper bar output terminal, 23-power positive copper bar, 231-power positive copper bar input terminal, 232-power positive copper bar output terminal, 24-power negative copper bar, 241 -power negative copper bar input terminal, 242-power negative copper bar output terminal, 25-at least three stages of filter components, 251-first-stage filter component, 252-second-stage filter component, 252a-upper part of the second-stage filter component, 252b-lower part of the second-stage filter component, 253-third-stage filter component, 253a-upper part of the third-stage filter component, 253b-lower part of the third-stage filter component, 26-printed circuit board, 27-electrical connector, 28-current sensor, X1-first direction, X2-second direction.

### DETAILED DESCRIPTION

Example embodiments will be described in detail herein, examples of which are illustrated in the accompanying drawings. When following description refers to the drawings, unless otherwise indicated, same numerals in different drawings indicate same or similar elements. The implementations set forth in the following description of example embodiments do not represent all implementations consistent with the present application. Instead, they are merely examples of apparatuses consistent with aspects related to the present application as recited in the appended claims.

The terminology used herein is for the purpose of describing particular embodiments only and is not intended to be limiting of the application. Unless otherwise defined, the technical terms or scientific terms used in the present application should have the ordinary meanings understood by those of ordinary skill in the art to which the present application belongs. "First", "second", and similar words used in the specification and claims of the present application do not indicate any order, quantity, or importance, but are merely used to distinguish between different components. Similarly, similar words such as "a" or "an" do not indicate quantity limitation, but indicate that there is at least one. Only "one" will be described separately. "Multiple" or "several" means two or more. Unless otherwise indicated, terms such as "front", "rear", "lower", and/or "upper" are merely for ease of description, and are not limited to one position or one spatial orientation. Similar words such as "include" or "comprise" mean that the elements or objects before "include" or "comprise" cover the elements or objects listed after "include" or "comprise" and their equivalents, and do not exclude other elements or objects. Similar words such as "connect" or "couple" are not limited to physical or mechanical connections, and may include electrical connections, whether direct or indirect. The singular forms "a", "said" and "the" used in the specification of the present disclosure and the appended claims are also intended to include plural forms, unless the context clearly indicates other meanings. It will also be understood that the term "and/or" as used herein refers to and encompasses any and all possible combinations of one or more of the associated listed items.

The 800 V high voltage and high power density electric drive controller represented by the third generation wide bandgap silicon carbide (SiC) power semiconductor has the advantages of high switching frequency, low loss and good temperature resistance to obtain large-scale applications, but also brings more serious electromagnetic interference problems. When the SiC power semiconductor device in the electric drive controller operates at a high speed, a high change rate of the du/dt voltage and a high change rate of the di/dt current will be generated, resulting in electromagnetic interference. Electromagnetic interference mainly includes radiation interference and conduction interference. The radiation interference refers to an electromagnetic wave generated by a product, which affects the normal operation of the electronic device through space interference, and the conduction interference refers to that an interference source affects the normal operation of other electronic devices in the form of voltage and current through a coupling path conducted by a high and low voltage wiring harness. In addition, interference may be classified into differential-mode interference and common-mode interference, where common-mode interference is a main factor that causes an electric drive controller to fail to meet a specified requirement. However, for a filter of a common direct-current power supply, stray inductance is relatively serious, and the filter insertion loss is high; the volume structure is inflexible and the output is easily affected by high-frequency coupling, and there are problems of unqualification and high maintenance cost in a high frequency band, which is not conducive to the popularization and application of platforms.

Embodiments of the present application discloses a filter circuit and filter for a direct-current power supply, an electric drive controller, and a vehicle. The filter circuit for the direct-current power supply includes a positive direct-current bus, a negative direct-current bus, a charging line, and at least three stages of filter circuits. The positive direct-current bus includes a positive direct-current bus input terminal and a positive direct-current bus output terminal. The negative direct-current bus includes a negative direct-current bus input terminal and a negative direct-current bus output terminal. The charging line includes a charging line input terminal and a charging line output terminal. The at least three stages of filter circuits are respectively connected between the positive direct-current bus input terminal and the positive direct-current bus output terminal, between the negative direct-current bus input terminal and the negative direct-current bus output terminal, and between the charging line input terminal and the charging line output terminal.

The filter circuit and filter for the direct-current power supply, the electric drive controller, and the vehicle in the embodiments of the present application can supply power to the motor drive and at the same time implement the filtering function based on the boost function, so that a very high resistance to insertion loss can be achieved, and a relatively strict filtering requirement can be met.

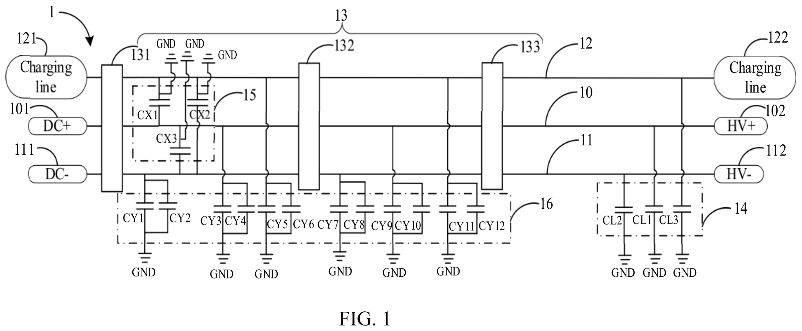

FIG. 1 is a circuit diagram of a filter circuit for a direct-current power supply according to an embodiment of the present application. As shown in FIG. 1, the filter circuit 1 for the direct-current power supply includes a positive direct-current bus 10, a negative direct-current bus 11, a charging line 12, and at least three stages of filter circuits 13. The positive direct-current bus 10 includes a positive direct-current bus input terminal 101 and a positive direct-current bus output terminal 102. The negative direct-current bus 11 includes a negative direct-current bus input terminal 111 and a negative direct-current bus output terminal 112. The charging line 12 includes a charging line input terminal 121 and a charging line output terminal 122. The at least three stages of filter circuits 13 are respectively connected between the positive direct-current bus input terminal 101 and the positive direct-current bus output terminal 102, between the negative direct-current bus input terminal 111 and the negative direct-current bus output terminal 112, and between the charging line input terminal 121 and the charging line output terminal 122.

In an embodiment, the charging line and the direct-current bus (the positive direct-current bus and the negative direct-current bus) are integrated as a whole, and at least three stages of filter circuits 13 are disposed between the integrated input terminals and output terminals, so that power can be supplied to the motor drive and at the same time a filtering function can be implemented on the basis of a boost function, thereby achieving a high resistance to insertion loss, and meeting a relatively strict filtering requirement.

In an embodiment shown in FIG. 1, the at least three stages of filter circuits 13 include a first-stage filter magnetic ring 131, a second-stage filter magnetic ring 132, and a third-stage filter magnetic ring 133. The first-stage filter magnetic ring 131, the second-stage filter magnetic ring 132, and the third-stage filter magnetic ring 133 are sequentially connected at intervals between the positive direct-current bus input terminal 101 and the positive direct-current bus output terminal 102, between the negative direct-current bus input terminal 111 and the negative direct-current bus output terminal 112, and between the charging line input terminal 121 and the charging line output terminal 122. The first-stage filter magnetic ring 131 is configured to eliminate low-frequency electromagnetic interference. The second-stage filter magnetic ring 132 and the third-stage filter magnetic ring 133 are configured to eliminate high-frequency electromagnetic interference. The first-stage filter magnetic ring 131, the second-stage filter magnetic ring 132 and the third-stage filter magnetic ring 133 are connected at intervals, which can supply power to the motor drive and at the same time realize the filtering function on the basis of the boost function, and can achieve a high resistance to insertion loss and meet the relatively strict filtering requirements.

In an embodiment shown in FIG. 1, the first-stage filter magnetic ring 131 is disposed closer to the positive direct-current bus input terminal 101, the negative direct-current bus input terminal 111, and the charging line input terminal 121 relative to the second-stage filter magnetic ring 132 and the third-stage filter magnetic ring 133. As the input terminals of the positive direct-current bus 10, the negative direct-current bus 11 and the charging line 12 have much low-frequency electromagnetic interference, in this embodiment, the first-stage filter magnetic ring 131 is disposed closer to the positive direct-current bus input terminal 101, the negative direct-current bus input terminal 111 and the charging line input terminal 121, which can eliminate low-frequency electromagnetic interference and make the signal stable and reliable.

In an embodiment shown in FIG. 1, the at least three stages of filter circuits 13 further include multiple direct-current support capacitors 14 respectively connected between the positive direct-current bus 10 and a ground terminal GND, between the negative direct-current bus 11 and a ground terminal GND, and between the charging line 12 and a ground terminal GND. In an embodiment shown in FIG. 1, connection points between the multiple direct-current support capacitors 14 and the positive direct-current bus 10, the negative direct-current bus 11, and the charging line 12 are respectively located between the third-stage filter magnetic ring 133 and the positive direct-current bus output terminal 102, between the third-stage filter magnetic ring 133 and the negative direct-current bus output terminal 112, and between the third-stage filter magnetic ring 133 and the charging line output terminal 122.

The multiple direct-current support capacitors 14 in this embodiment may perform smooth filtering on output voltages of the positive direct-current bus 10, the negative direct-current bus 11, and the charging line 12, so that voltage fluctuations on the charging line 12 and the direct-current bus (the positive direct-current bus 10 and the negative direct-current bus 11) are kept within an allowed range. The direct-current support capacitors 14 have the advantages of high voltage resistance, high current resistance, low impedance, low inductance, small capacity loss, small leakage current, safety and reliability, etc.

For example, in an embodiment shown in FIG. 1, the multiple direct-current support capacitors 14 may specifically include a first direct-current support capacitor CL1, a second direct-current support capacitor CL2, and a third direct-current support capacitor CL3. The first direct-current support capacitor CL1 is connected between the positive direct-current bus 10 and the ground terminal GND, the second direct-current support capacitor CL2 is connected between the negative direct-current bus 11 and the ground terminal GND, and the third direct-current support capacitor CL3 is connected between the charging line 12 and the ground terminal GND. The first direct-current support capacitor CL1 may perform smooth filtering on the output voltage of the positive direct-current bus 10, so that a voltage fluctuation on the positive direct-current bus 10 is kept within an allowable range, thereby suppressing ripples and preventing backflow. The second direct-current support capacitor CL2 may perform smooth filtering on the output voltage of the negative direct-current bus 11, so that a voltage fluctuation on the negative direct-current bus 11 is kept within an allowable range, thereby suppressing ripples and preventing backflow. The third direct-current support capacitor CL3 may perform smooth filtering on the output voltage of the charging line 12, so that the voltage fluctuation on the charging line 12 is kept within an allowable range, thereby suppressing ripples and preventing backflow.

In an embodiment shown in FIG. 1, one end of each of the multiple direct-current support capacitors 14 is connected to the ground terminal GND, where a connection manner thereof is flexible. In some other embodiments, one end of each of the multiple direct-current support capacitors 14 may also be connected to the same ground terminal GND, and the ground terminal in this connection manner is relatively stable and reliable.

In an embodiment shown in FIG. 1, the at least three stages of filter circuits 13 may further include at least one differential-mode circuit 15 connected to every two of the positive direct-current bus 10, the negative direct-current bus 11, and the charging line 12. In an embodiment shown in FIG. 1, the differential-mode circuit 15 includes at least one differential-mode capacitor CX. In some embodiments, each differential-mode capacitor is connected between two of the positive direct-current bus 10, the negative direct-current bus 11, and the charging line 12. This arrangement can improve the performance of eliminating differential-mode interference signals.

For example, in an embodiment shown in FIG. 1, the differential-mode capacitor CX may specifically include a first differential-mode capacitor CX1, a second differential-mode capacitor CX2, and a third differential-mode capacitor CX3. The first differential-mode capacitor CX1 is connected between the positive direct-current bus 10 and the charging line 12, and is configured to eliminate differential-mode interference between the positive direct-current bus 10 and the charging line 12. The second differential-mode capacitor CX2 is connected between the negative direct-current bus 11 and the charging line 12, and is configured to eliminate differential-mode interference between the negative direct-current bus 11 and the charging line 12. The third differential-mode capacitor CX3 is connected between the positive direct-current bus 10 and the negative direct-current bus 11, and is configured to eliminate differential-mode interference between the positive direct-current bus 10 and the negative direct-current bus 11.

In an embodiment shown in FIG. 1, connection points between the differential-mode circuits 15 and the positive direct-current bus 10, the negative direct-current bus 11, and the charging line 12 are respectively located between the first-stage filter magnetic ring 131 and the second-stage filter magnetic ring 132. In this way, mutual interference between the first-stage filter magnetic ring 131 and the second-stage filter magnetic ring 132 can be reduced.

In an embodiment shown in FIG. 1, the at least three stages of filter circuits 13 may further include one or more common-mode circuits 16 respectively connected between the positive direct-current bus 10 and the ground terminal GND, between the negative direct-current bus 11 and the ground terminal GND, and between the charging line 12 and the ground terminal GND. In an embodiment shown in FIG. 1, connection points between the common-mode circuits 16 and the positive direct-current bus 10, the negative direct-current bus 11, and the charging line 12 are respectively located between the first-stage filter magnetic ring 131 and the second-stage filter magnetic ring 132, and between the second-stage filter magnetic ring 132 and the third-stage filter magnetic ring 133. In an embodiment shown in FIG. 1, the common-mode circuit 16 includes at least two common-mode capacitors CY. In some embodiments, each common-mode capacitor is connected between one of the positive direct-current bus 10, the negative direct-current bus 11, and the charging line 12 and the ground terminal. This arrangement can improve the performance of eliminating common-mode interference.

For example, in an embodiment shown in FIG. 1, common-mode capacitors CYs with non-grounded connection points between the first-stage filter magnetic ring 131 and the second-stage filter magnetic ring 132 may specifically include: a first common-mode capacitor CY1 and a second common-mode capacitor CY2, connected between the negative direct-current bus 11 and the ground terminal GND, and configured to eliminate common-mode interference between the negative direct-current bus 11 and the ground terminal GND; a third common-mode capacitor CY3 and a fourth common-mode capacitor CY4, connected between the positive direct-current bus 10 and the ground terminal GND, and configured to eliminate common-mode interference between the positive direct-current bus 10 and the ground terminal GND; and a fifth common-mode capacitor CY5 and a sixth common-mode capacitor CY6, connected between the charging line 12 and the ground terminal GND, and configured to eliminate common-mode interference between the charging line 12 and the ground terminal GND.

For another example, in the embodiment shown in FIG. 1, common-mode capacitors CYs with non-grounded connection points between the second-stage filter magnetic ring 132 and the third-stage filter magnetic ring 133, may specifically include: a seventh common-mode capacitor CY7 and an eighth common-mode capacitor CY8, connected between the negative direct-current bus 11 and the ground terminal GND, and configured to eliminate common-mode interference between the negative direct-current bus 11 and the ground terminal GND; a ninth common-mode capacitor CY9 and a tenth common-mode capacitor CY10, connected between the positive direct-current bus 10 and the ground terminal GND, and configured to eliminate common-mode interference between the positive direct-current bus 10 and the ground terminal GND; and an eleventh common-mode capacitor CY11 and a twelfth common-mode capacitor CY12, connected between the charging line 12 and the ground terminal GND, and configured to eliminate common-mode interference between the charging line 12 and the ground terminal GND.

In addition, in the embodiment shown in FIG. 1, one end of each of the multiple common-mode circuits 16 is connected to the ground terminal GND, where a connection manner thereof is flexible. In some other embodiments, one end of the multiple common-mode circuits 16 may be connected to the same ground terminal GND, and the ground terminal in this connection manner is relatively more stable and reliable.

In an embodiment shown in FIG. 1, the first-stage filter magnetic ring 131 may include an amorphous magnetic ring. The amorphous magnetic ring is a magnetic element processed with an amorphous material, and can well inhibit low-frequency interference signals. Materials used as the amorphous material can be classified into iron-based amorphous, cobalt-based amorphous, etc. In this embodiment, the amorphous magnetic ring can be replaced with magnetic rings of different shapes and materials according to actual filtering requirements of different products to achieve a desired inductance.

In an embodiment shown in FIG. 1, the second-stage filter magnetic ring 132 may include a ferrite magnetic ring. In an embodiment shown in FIG. 1, the third-stage filter magnetic ring 133 may also include a ferrite magnetic ring, for example, made of a ferrite material (Mn-Zn). The ferrite magnetic ring has a good inhibitory effect on high-frequency interference signals.

An embodiment of the present application further provides a filter 2 for a direct-current power supply, and the filter 2 for the direct-current power supply is provided with the filter circuit 1 for the direct-current power supply shown in the embodiment of FIG. 1. The direct-current power supply may include a direct-current boost power supply (boost power supply). The filter 2 integrates the charging line 12 and the direct-current bus (the positive direct-current bus 10 and the negative direct-current bus 11) as a whole by disposing the filter circuit 1 for the direct-current power supply shown in the embodiment of FIG. 1, and at least three stages of filter circuits 13 are disposed between the integrated input terminals and output terminals, so that power can be supplied to the motor drive and at the same time a filtering function can be implemented on the basis of a boost function, and a very high resistance to insertion loss can be achieved, thereby meeting a relatively strict filtering requirement.

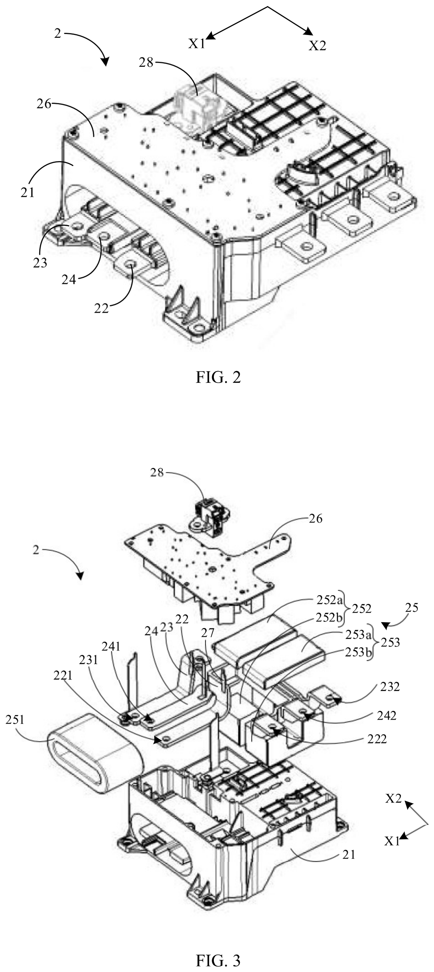

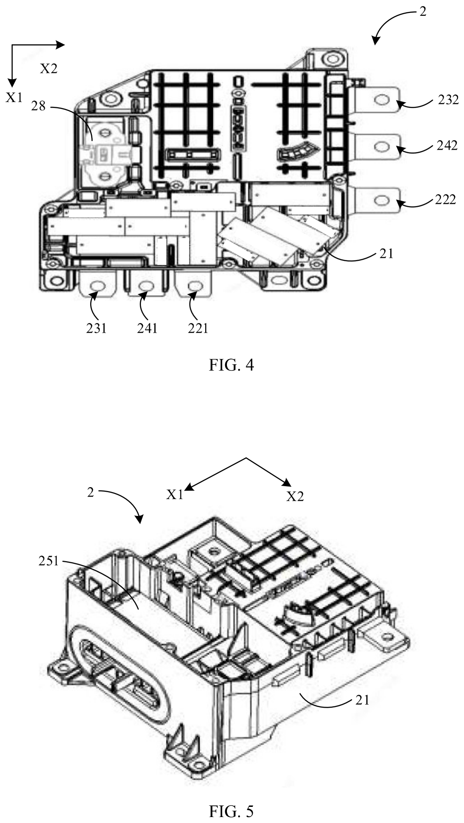

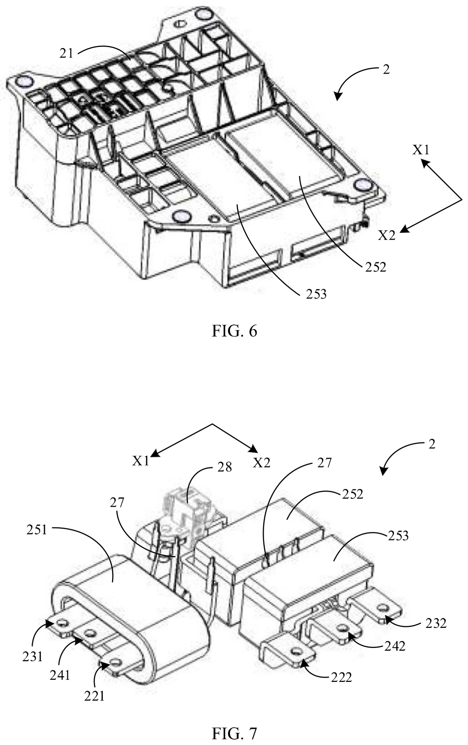

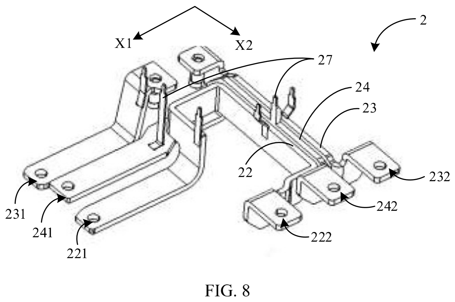

FIG. 2 is a schematic structural diagram of an embodiment of a filter 2 for a direct-current power supply according to the present application. FIG. 3 is an exploded view of the filter 2 of FIG. 2. FIG. 4 is a structural top view of a filter 2 for a direct-current power supply shown in FIG. 2. FIG. 5 is a structural diagram of a part of a filter 2 for a direct-current power supply shown in FIG. 2. FIG. 6 is a structural diagram of a part of a filter 2 for a direct-current power supply shown in FIG. 2. FIG. 7 is a structural diagram of a part of a filter 2 for a direct-current power supply shown in FIG. 2. FIG. 8 is a structural diagram of a part of a filter 2 for a direct-current power supply shown in FIG. 2. As shown in FIG. 2 to FIG. 8, the filter 2 for the direct-current power supply includes a base 21, a power charging copper bar 22, a power positive copper bar 23, a power negative copper bar 24, and at least three stages of filter components 25. The power charging copper bar 22, the power positive copper bar 23, the power negative copper bar 24, and the at least three stage filter components 25 are all mounted on the base 21. The base 21 is provided with an accommodating space for accommodating the power charging copper bar 22, the power positive copper bar 23, the power negative copper bar 24 and at least three stages of filter components 25. The at least three stages of filter components 25 are electrically connected to the power charging copper bar 22, the power positive copper bar 23, and the power negative copper bar 24, respectively. In this embodiment, the power positive copper bar 23 may be a positive copper busbar. The power negative copper bar 24 may be a negative copper busbar.

In this embodiment, the power charging copper bar 22, the power positive copper bar 23, the power negative copper bar 24, and the at least three stages of filter components 25 are all mounted on the base 21, and the at least three stages of filter components 25 are electrically connected to the power charging copper bar 22, the power positive copper bar 23, and the power negative copper bar 24, to supply power to the motor drive and at the same time implement the filtering function on the basis of the boost function, so that a very high resistance to insertion loss can be achieved, a relatively harsh filtering requirement is met, where integration is high, a structure is simple, a layout is compact, a volume is small, and maintenance costs are low.

In embodiments shown in FIG. 2 to FIG. 3, and FIG. 7 to FIG. 8, the base 21 extends along a first direction X1 and a second direction X2 that are located in a same plane and intersect with each other. In this embodiment, the first direction X1 and the second direction X2 may be perpendicularly intersected. The power charging copper bar 22 includes a power charging copper bar input terminal 221 and a power charging copper bar output terminal 222 that are connected to each other. In this embodiment, the power charging copper bar input terminal 221 and the power charging copper bar output terminal 222 are both bent and connected to the filter components 25. The power positive copper bar 23 includes a power positive copper bar input terminal 231 and a power positive copper bar output terminal 232 that are connected to each other. The power positive copper bar input terminal 231 and the power positive copper bar output terminal 232 are both bent and connected to the filter components 25. The power negative copper bar 24 includes a power negative copper bar input terminal 241 and a power negative copper bar output terminal 242 that are connected to each other. The power negative copper bar input terminal 241 and the power negative copper bar output terminal 242 are both bent and connected to the filter components 25. In addition, as shown in FIG. 2 to FIG. 8, the power charging copper bar input terminal 221, the power positive copper bar input terminal 231 and the power negative copper bar input terminal 241 extend side by side along the first direction X1, and the power charging copper bar output terminal 222, the power positive copper bar output terminal 232 and the power negative copper bar output terminal 242 extend side by side along the second direction X2. In this way, by combining the placement form of parallel disposed copper bars and the placement form of vertically laminated copper bars, the bending angle of the copper bar can be adjusted to be compatible with various spatial structures, which has the advantages of simple structure, high integration, compact layout and low maintenance cost.

In the embodiments shown in FIG. 2 to FIG. 3, and FIG. 7 to FIG. 8, the power charging copper bar input terminal 221, the power positive copper bar input terminal 231, and the power negative copper bar input terminal 241 respectively have a height difference relative to a plane in which the first direction X1 and the second direction X2 are located, and the height differences are different. In an embodiment, it is assumed that the plane where the first direction X1 and the second direction X2 are located is a horizontal plane. The power charging copper bar input terminal 221, the power positive copper bar input terminal 231, and the power negative copper bar input terminal 241 respectively have a height difference relative to the horizontal plane, and the height differences may be different from each other. With this arrangement, the input signals of the power charging copper bar input terminal 221, the power positive copper bar input terminal 231 and the power negative copper bar input terminal 241 can be prevented from interfering with each other, so that the input signals are stable and reliable.

In the embodiments shown in FIG. 2 to FIG. 3 and FIG. 7 to FIG. 8, the power charging copper bar output terminal 222, the power positive copper bar output terminal 232, and the power negative copper bar output terminal 242 have a height difference relative to a plane in which the first direction X1 and the second direction X2 are located, and the height differences are different. In an embodiment, it is assumed that the plane where the first direction X1 and the second direction X2 are located is a horizontal plane. The power charging copper bar output terminal 222, the power positive copper bar output terminal 232, and the power negative copper bar output terminal 242 respectively have a height difference relative to the horizontal plane, and the height differences may be different from each other. With this arrangement, the output signals of the power charging copper bar output terminal 222, the power positive copper bar output terminal 232 and the power negative copper bar output terminal 242 can be prevented from interfering with each other, so that the output signals are stable and reliable.

In the embodiments shown in FIG. 2 to FIG. 3 and FIG. 7 to FIG. 8, the power charging copper bar input terminal 221, the power positive copper bar input terminal 231, and the power negative copper bar input terminal 241 respectively have a height difference relative to the power charging copper bar output terminal 222, the power positive copper bar output terminal 232, and the power negative copper bar output terminal 242 in the plane where the first direction X1 and the second direction X2 are located. In an embodiment, it is assumed that the plane where the first direction X1 and the second direction X2 are located is a horizontal plane. The power charging copper bar input terminal 221 may have a height difference on the horizontal plane relative to the power charging copper bar output terminal 222. The power positive copper bar input terminal 231 may have a height difference on the horizontal plane relative to the power positive copper bar output terminal 232. The power negative copper bar input terminal 241 may have a height difference on the horizontal plane relative to the power negative copper bar output terminal 242. This arrangement can further avoid signal interference and make signal transmission more stable and reliable.

In the embodiments shown in FIG. 2 to FIG. 3 and FIG. 7 to FIG. 8, the power positive copper bar 23 may be disposed closer to an outer edge of the base 21 relative to the power negative copper bar 24 and the power charging copper bar 22; and the power charging copper bar 22 may be disposed closer to an inner middle region of the base 21 relative to the power positive copper bar 23 and the power negative copper bar 24. For example, the power positive copper bar 23, the power negative copper bar 24, and the power charging copper bar 22 may be sequentially arranged from the edge of the base 21 to the middle area. In addition, the power positive copper bar input terminal 231 and the power positive copper bar output terminal 232 may respectively extend in two directions. For example, the power positive copper bar input terminal 231 extends along the first direction X1, and the power positive copper bar output terminal 232 extends along the second direction X2. Similarly, the power negative copper bar input terminal 241 and the power negative copper bar output terminal 242 may also respectively extend in two directions (the power negative copper bar input terminal 241 extends along the first direction X1 and the power negative copper bar output terminal 242 extends along the second direction X2), and the power charging copper bar input terminal 221 and the power charging copper bar output terminal 222 may also respectively extend in two directions (the power charging copper bar input terminal 221 extends along the first direction X1 and the power charging copper bar output terminal 222 extends along the second direction X2).

In this embodiment, by arranging the copper bars along two vertical directions, the space of the bending part can be fully utilized, and through the structural design of parallel laminated copper bars, where parallel refers to parallel projection on the horizontal plane, and laminated refers to different height differences relative to the horizontal plane, which can maximize the laminated length range of the power positive copper bar 23, the power negative copper bar 24 and the power charging copper bar 22, so that magnetic fields of the power positive copper bar 23, the power negative copper bar 24 and the power charging copper bar 22 cancel each other, and can effectively reduce stray inductance. In addition, in this layout manner, a structure is simple, a layout is compact, integration is high, and a volume is small. It should be noted that an isolation component (not shown in the figure) is disposed between adjacent copper bars for isolation, to prevent electrical connection between the adjacent copper bars.

In the embodiments shown in FIG. 3 and FIG. 5 to FIG. 7, the at least three stages of filter components 25 include a first-stage filter component 251, a second-stage filter component 252, and a third-stage filter component 253, which are respectively sleeved on the power charging copper bar 22, the power positive copper bar 23, and the power negative copper bar 24, and are respectively connected to the power charging copper bar 22, the power positive copper bar 23, and the power negative copper bar 24.

With reference to FIG. 1, the first-stage filter component 251 shown in FIG. 2 to FIG. 8 may be the first-stage filter magnetic ring 131, and the first-stage filter magnetic ring 131 may be an amorphous magnetic ring. The second-stage filter component 252 may be the second-stage filter magnetic ring 132, and the third-stage filter component 253 may be the third-stage filter magnetic ring 133. The second-stage filter magnetic ring 132 and the third-stage filter magnetic ring 133 may be ferrite magnetic rings. The first-stage filter component 251 is configured to eliminate low-frequency electromagnetic interference. The second-stage filter component 252 and the third-stage filter component 253 are configured to eliminate high-frequency electromagnetic interference. In this way, power can be supplied to the motor drive and at the same time the filtering function can be realized on the basis of the boost function, which can achieve a high resistance to insertion loss, thereby meeting the relatively strict filtering requirements.

In the embodiments shown in FIG. 5 and FIG. 7, the first-stage filter component 251 is disposed closer to the power charging copper bar input terminal 221, the power positive copper bar input terminal 231, and the power negative copper bar input terminal 241 relative to the second-stage filter component 252 and the third-stage filter component 253. As the input terminals of the power charging copper bar 22, the power positive copper bar 23 and the power negative copper bar 24 have much low-frequency electromagnetic interference, the first-stage filter component 251 is arranged closer to the power charging copper bar input terminal 221, the power positive copper bar input terminal 231 and the power negative copper bar input terminal 241, which can eliminate the low-frequency electromagnetic interference and make the signal stable and reliable.

In the embodiments shown in FIG. 3 and FIG. 5 to FIG. 7, the first-stage filter component 251 is arranged to extend along the first direction X1, and the second-stage filter component 252 and the third-stage filter component 253 are arranged at intervals along the second direction X2. In this way, the spatial structure of the load can be compatible, the layout is compact, and mutual interference between the first-stage filter component 251, the second-stage filter component 252, and the third-stage filter component 253 is prevented.

In the embodiments shown in FIG. 3 and FIG. 5 to FIG. 7, the first-stage filter component 251 is integrally formed and has a ring structure, and the power charging copper bar input terminal 221, the power positive copper bar input terminal 231, and the power negative copper bar input terminal 241 may all pass through the first-stage filter component 251 and extend from the first-stage filter component 251 to the outside of the base 21.

In the embodiments shown in FIG. 2 to FIG. 8, the second-stage filter component 252 may be a split structure, including an upper part 252a of the second-stage filter component and a lower part 252b of the second-stage filter component. The upper part 252a of the second-stage filter component and the lower part 252b of the second-stage filter component can be vertically assembled by inserting, so as to be assembled above and below the power charging copper bar 22, the power positive copper bar 23, and the power negative copper bar 24.

In the embodiments shown in FIG. 2 to FIG. 8, the third-stage filter component 253 may also be a split structure, including an upper part 253a of the third-stage filter component and a lower part 253b of the third-stage filter component. The upper part 253a of the third-stage filter component and the lower part 253b of the third-stage filter component can be vertically assembled by inserting, so as to be assembled above and below the power charging copper bar 22, the power positive copper bar 23, and the power negative copper bar 24.

In order to be compatible with a complex spatial structure, the first-stage filter component 251 is assembled parallel to the input terminal of the copper bar, and a size of the magnetic ring is compatible with different spatial sizes for actual adjustment. The second-stage filter components 252 and the third-stage filter component 253 are assembled in segments, and the assembly direction is orthogonal to the assembly direction of the first-stage filter component 251. In this way, configuration of the magnetic ring is convenient and flexible, takes into account the structure size and process, and facilitates the promotion and application of the platform.

In the embodiments shown in FIG. 2 to FIG. 3, the filter 2 may further include a printed circuit board 26 covering the top of the base 21. The printed circuit board 26 is assembled on the top of the base 21, on one hand, the power charging copper bar 22, the power positive copper bar 23, the power negative copper bar 24, and the at least three stages of filter components 25 are assembled in the base 21, and are fixed stably; and on the other hand, the power positive copper bar 23, the power negative copper bar 24, and the at least three stages of filter components 25 are electrically connected to the printed circuit board 26, so that the electrical connection is stable and reliable, and signal transmission is stable. In this embodiment, the printed circuit board 26 is used to replace the traditional direct connection mode of the capacitor pins, which not only facilitates the capacitor layout, but also reduces the parasitic resistance and inductance through the wider wiring on the printed circuit board 26.

In this embodiment, on the basis of the parallel laminated vertical structure of the copper bar, screws are fastened to the printed circuit board 26 to obtain power, which is convenient for installation and disassembly. In this embodiment, protection measures, such as a magnetic ring, a Y capacitor (CX capacitor), and an X capacitor (CY capacitor), are selectively designed from the system level to prevent structural damage. In this embodiment, multiple differential-mode components (not shown), multiple common-mode components (not shown), and multiple direct-current support capacitor components (not shown) are disposed on a surface of the printed circuit board 26 facing the base 21. As shown in FIG. 1, the direct-current support capacitor component may be the direct-current support capacitors 14, which are respectively connected between the power charging copper bar 22 and the ground terminal, between the power positive copper bar 23 and the ground terminal, and between the power negative copper bar 24 and the ground terminal. The differential-mode component may be differential-mode capacitors of the differential-mode circuit 15. The differential-mode component includes at least one differential-mode capacitor, and each differential-mode capacitor is connected between two of the power charging copper bar 22, the power positive copper bar 23, and the power negative copper bar 24. The common-mode component may be the common-mode capacitors of the common-mode circuit 16. The common-mode component includes at least two common-mode capacitors, and each common-mode capacitor is connected between one of the power positive copper bar 23, the power negative copper bar 24, and the power charging copper bar 22 and the ground terminal. In addition, the printed circuit board 26 further includes other elements, which is not limited in the present application. In this embodiment, the multiple differential-mode components, the multiple common-mode components, and the multiple direct-current support capacitor components are disposed in the filter 2, and the built-in arrangement can reduce the size of the product in the height direction, so that the structure is compact and the volume is reduced.

With reference to the embodiments shown in FIG. 3 and FIG. 7 to FIG. 8, the filter 2 may further include multiple electrical connectors 27, which are respectively disposed on a side of the power charging copper bar 22, the power positive copper bar 23, and the power negative copper bar 24 facing the printed circuit board 26, extend upward from tops of the power charging copper bar 22, the power positive copper bar 23, and the power negative copper bar 24, and are electrically connected to the multiple differential-mode components, the multiple common-mode components, and the multiple direct-current support capacitor components of the printed circuit board 26 in a vertical manner. In this embodiment, the electrical connector 27 may be a plug-in copper bar, which is integrally formed with the power charging copper bar 22, the power positive copper bar 23, and the power negative copper bar 24, respectively. In this embodiment, by providing multiple plug-in copper bars, on the one hand, the structural layout is compact and the molding process is simple, and on the other hand, the plug-in connection with the components on the printed circuit board 26 is realized, the signal is stable, and the assembly is convenient. In this embodiment, the electrical connector 27 may be a copper bar pin, which is different from a conventional bolt fixing, and can not only ensure a current passing capability, but also achieve a filtering effect.

In this embodiment, the filter 2 may further include a grounded copper bar (not shown). One end of each of the multiple differential-mode components, the multiple common-mode components, and the multiple direct-current support capacitor components is connected to a grounded copper bar, and the grounded copper bar is connected to a ground terminal. In some embodiments, the differential-mode components are grounded through a Y capacitor. In this way, the grounded terminals of the multiple differential-mode components, the multiple common-mode components, and the multiple direct-current support capacitor components can be together connected to the grounded copper bar, which is, on the one hand, convenient for connection and maintenance, and on the other hand, has a large grounded area and stable grounded signals. In addition, in combination with the actual space, multiple paths are connected to the same grounded copper bar in parallel, and the length of the common-mode grounded line is reduced to the greatest extent by means of multi-point parallel connection to the ground, the grounded impedance is reduced, and high-frequency clutter is filtered out. In this embodiment, the filter grounding of the common-mode capacitor and the product fixing hole position are integrated, which can reduce the number of fixing hole positions and further reduce the volume.

With reference to the embodiments shown in FIG. 2 to FIG. 4 and FIG. 7, the filter 2 may further include a current sensor 28 disposed on the power positive copper bar 23. The current sensor 28 is configured to detect a current of the power positive copper bar 23, that is, detect a current of the direct-current bus loop, and can monitor the current of the direct-current bus loop in real time, which is safe and reliable. In this embodiment, the filter 2 may further include a voltage sensor, which is highly integrated.

An embodiment of the present application further provides an electric drive controller, including the filter 2 for the direct-current power supply according to the above embodiments of FIG. 2 to FIG. 8. In this embodiment, the electric drive controller is provided with the filter 2 for the direct-current power supply shown in the embodiments of FIG. 2 to FIG. 8. This embodiment mainly addresses the problem of poor/common-mode interference caused by the high voltage, high switching frequency, and wide bandgap power module operation of the electric drive controller, and under the premise of ensuring the performance, size, and cost, through the solution of distributively arranging at least three stages of filters 2 in the electric drive controller, the first-stage filter component 251, the second-stage filter component 252, and the third-stage filter component 253 are externally arranged to facilitate material formula adjustment, and the common-mode capacitor of the common-mode component, the differential-mode capacitor of the differential-mode component, and the direct-current support capacitor of the direct-current support capacitor component are internally arranged to facilitate structural integration and achieve a good electromagnetic compatibility design target requirement. On the premise of not changing the size, the electric drive controller is selected from the entire control system level, which realizes the flexible configuration of design topology and structure optimization, ensures the reliability, and is beneficial to the promotion and application of the platform, and can be applied to the system solutions of the front drive and rear drive, the double motor and the four motor. An embodiment of the present application further provides a vehicle, including the electric drive controller in the above embodiments, which is stable and reliable, can meet a good electromagnetic compatibility design objective requirement, has better stability, better safety, and better compatibility, and is conducive to promotion and application of a platform.

The above embodiments are some embodiments of the present application, but are not intended to limit the present application, and any modification, equivalent replacement, improvement, and the like made without departing from the spirit and principle of this application shall fall within the protection scope of the present application.

## Claims

1. A filter circuit for a direct-current power supply, comprising:
a positive direct-current bus, comprising a positive direct-current bus input terminal and a positive direct-current bus output terminal;
a negative direct-current bus, comprising a negative direct-current bus input terminal and a negative direct-current bus output terminal;
a charging line, comprising a charging line input terminal and a charging line output terminal; and
at least three stages of filter circuits, respectively connected between the positive direct-current bus input terminal and the positive direct-current bus output terminal, between the negative direct-current bus input terminal and the negative direct-current bus output terminal, and between the charging line input terminal and the charging line output terminal.

2. The filter circuit for the direct-current power supply according to claim 1, wherein the at least three stages of filter circuits comprise a first-stage filter magnetic ring, a second-stage filter magnetic ring, and a third-stage filter magnetic ring; wherein the first-stage filter magnetic ring, the second-stage filter magnetic ring, and the third-stage filter magnetic ring are sequentially connected at intervals between the positive direct-current bus input terminal and the positive direct-current bus output terminal, between the negative direct-current bus input terminal and the negative direct-current bus output terminal, and between the charging line input terminal and the charging line output terminal.

3. The filter circuit for the direct-current power supply according to claim 2, wherein the first-stage filter magnetic ring is disposed closer to the positive direct-current bus input terminal, the negative direct-current bus input terminal, and the charging line input terminal relative to the second-stage filter magnetic ring and the third-stage filter magnetic ring.

4. The filter circuit for the direct-current power supply according to claim 2, wherein the at least three stages of filter circuits further comprise multiple direct-current support capacitors respectively connected between the positive direct-current bus and a ground terminal, between the negative direct-current bus and the ground terminal, and between the charging line and the ground terminal.

5. The filter circuit for the direct-current power supply according to claim 4, wherein one terminal of each of the multiple direct-current support capacitors is connected to a same ground terminal; and/or
the multiple direct-current support capacitors are respectively located between the third-stage filter magnetic ring and the positive direct-current bus output terminal, between the third-stage filter magnetic ring and the negative direct-current bus output terminal, and between the third-stage filter magnetic ring and the charging line output terminal.

6. The filter circuit for the direct-current power supply according to claim 2, wherein the at least three stages of filter circuits further comprise one or more differential-mode circuits respectively connected between every two of the positive direct-current bus, the negative direct-current bus and the charging line.

7. The filter circuit for the direct-current power supply according to claim 6, wherein the one or more differential-mode circuits are located between the first-stage filter magnetic ring and the second-stage filter magnetic ring; and/or
the one or more differential-mode circuits comprise at least one differential-mode capacitor.

8. The filter circuit for the direct-current power supply according to claim 2, wherein the at least three stages of filter circuits further comprise one or more common-mode circuits respectively connected between the positive direct-current bus and a ground terminal, between the negative direct-current bus and the ground terminal, and between the charging line and the ground terminal.

9. The filter circuit for the direct-current power supply according to claim 8, wherein the one or more common-mode circuits are respectively located between the first-stage filter magnetic ring and the second-stage filter magnetic ring, and between the second-stage filter magnetic ring and the third-stage filter magnetic ring; and/or
one terminal of each of the one or more common-mode circuits is connected to a same ground terminal; and/or
the one or more common-mode circuits comprise at least two common-mode capacitors.

10. The filter circuit for the direct-current power supply according to claim 2, wherein the first-stage filter magnetic ring comprises an amorphous magnetic ring; and/or
the second-stage filter magnetic ring comprises a ferrite magnetic ring; and/or
the third-stage filter magnetic ring comprises a ferrite magnetic ring.

11. A filter for a direct-current power supply, wherein the filter of the direct-current power supply is internally provided with the filter circuit for the direct-current power supply according to any one of claims 1-10.

12. The filter according to claim 11, wherein the direct-current power supply comprises a direct-current boost power supply.

13. An electric drive controller, comprising the filter for the direct-current power supply according to claim 11.

14. A vehicle, comprising the electric drive controller according to claim 13.
